Europäisches Patentamt

European Patent Office

Office européen des brevets

(19)

(11) Veröffentlichungsnummer: **0 011 075**
**B1**

(12) **EUROPÄISCHE PATENTSCHRIFT**

(45) Veröffentlichungstag der Patentschrift: **22.06.83**

(21) Anmeldenummer: **79100131.6**

(22) Anmeldetag: **17.01.79**

(51) Int. Cl.³: **H 03 K 17/00,
H 01 G 1/005**

(54) Schaltungsanordnung zum berührungslosen Schalten von elektrischen Einrichtungen.

(30) Priorität: **22.09.78 CH 9901/78**

(43) Veröffentlichungstag der Anmeldung:
**28.05.80 Patentblatt 80/11**

(45) Bekanntmachung des Hinweises auf die Patenterteilung:
**22.06.83 Patentblatt 83/25**

(84) Benannte Vertragsstaaten:
**BE DE FR GB LU NL SE**

(56) Entgegenhaltungen:
**DE - A - 2 458 524
US - A - 3 392 349
US - A - 3 556 146**

(73) Patentinhaber: **Tschannen, Kurt
Schaffhauserstrasse 466
CH-8052 Zürich (CH)**

(72) Erfinder: **Tschannen, Kurt
Schaffhauserstrasse 466
CH-8052 Zürich (CH)**

(74) Vertreter: **Utiger, Heinrich, Prof. Dr. phil.
David Hessweg 16 Postfach 145
CH-8060 Zürich (CH)**

Courier Press, Leamington Spa, England.

## Schaltungsanordnung zum berührungslosen
## Schalten von elektrischen Einrichtungen

Die Erfindung bezieht sich auf eine Schaltungsanordnung zum berührungslosen Schalten von elektrischen Einrichtungen mit einem Impulsgenerator, der rechteckförmige Impulssignale kontinuierlich einem Signaleingang eines Sensorteiles zuführt, in welchem zwei in Serie geschaltete Kondensatoren angeordnet sind, die aus zwei auf der einen Seite des Sensorteiles angeordneten Metallplättchen und einem auf der anderen, dem Benutzer zugewandten Seite angeordneten dritten Metallplättchen, welches die beiden anderen Metallplättchen überdeckt, bestehen, und welcher einen Signalausgang aufweist, an dem von der Annäherung eines Körpers an das dritte Metallplättchen beeinflussbare Ausgangssignale abgegeben werden, welche entsprechend umgefomrt, ein Schaltelement steuern.

Es ist bekannt, dass bis anhin das Einschalten eines elektrischen Apparates, einer Lichtquelle oder einer in Gang zu setzenden Maschine vermittels mechanischer Betätigung eines mechanischen Schalters erfolgte. Solche mechanischen Schalter unterliegen einer gewissen Abnützung ihrer mechanischen Teile, die sich bewegen müssen. Zudem sind sie Quellen von Lärmerzeugungen, was unter Umständen als lästig empfunden wird.

Neuerdings sind auch elektronische Berührungsschalter bekannt geworden, die zum Ein- und Ausschalten berührt werden müssen, was für den menschlichen Körper in dem Sinne als nachteilig empfunden wird, als ein elektrischer Strom in dem Momente durch den Körper fliesst, in dem der Berührungsschalter berührt werden muss.

Die bis anhin bekannten elektronischen Schalter sind für kleinste Lasten nicht schaltbar; sie weisen zudem eine höhere Verlustleistung auf und sie sind gegen Steuerimpulse der Elektrizitätswerke sehr empfindlich. In bezug auf eine extrem hohe Störsicherheit sind sie ebenfalls sehr empfindlich und sie besitzen die unangenehme Eigenschaft, sich in einem bestimmten Masse zu erwärmen.

In der US—A—3 556 146 ist eine Schaltungsanordnung mit einem berührungslos zu betätigenden Sensorkopf bekannt, die in Wasserhähne eingebaut ist, wobei die Wasserhähne hiefür speziell angefertigt sein müssen, bei der durch einen Impulsgenerator kontinuierlich rechteckförmige Impulssignale einem Sensorkopf zugeführt werden, der auf der einen Seite zwei Kondensatorbeläge C1 und C2 aufweist und auf der gegenüberliegenden, dem Benützer zugekehrten Seite eine gemeinsame Elektrode E1, die die beiden gegenüberliegenden Kondensatorbelege überdeckt, so dass zwei in Serie geschaltete Kondensatoren entstehen, und dass am Ausgang des Sensorkopfes ein von der Kapazität des angenäherten Körpers beeinflusstes Ausgangssignal entsteht, welches entsprechend umgeformt, ein Schaltelement steuert.

Gemäss dem US-Patent 3 392 349 wird ein Verstärker für Dauerbetrieb beschrieben, dessen Relais dauernd angesteuert wird, derart, dass andauernd eine nicht unbeträchtliche Strommenge fliesst. Das Relais ist monostabil oder astabil. Der Schalter ist nicht zur berührungslosen Betätigung geeignet und der Kontakt zwischen der Masse und dem Sensorkopf muss vermittelst einer Pulvermasse hergestellt werden, damit eine Kapazitätsänderung erfolgt. Bei dieser Offenbarung handelt es sich um einen Wasserstandsanzeiger, wobei der Sensorkopf 11 gemäss Fig. 4 nicht vom Oszillator getrennt ist. Für die Herstellung der Speisespannung muss zudem ein Transformer verwendet werden.

In der DE 2 458 524 wird eine Steuer-Schaltungsanordnung beschrieben, in der der Sensorteil galvanisch mit den nachgeschalteten Transistoren verbunden ist. Ein berührungsloses Schalten ist somit nicht realisierbar.

Der vorliegenden Erfindung lieft die Aufgabe zugrunde, eine Schaltungsanordnung zum berührungslosen Schalten von elektrischen Einrichtungen zu realisieren, welche die genannten Nachteile vermeiden.

Die Erfindung besteht darin, die eingangs genannte Schaltungsanordnung zum berührungslosen Schalten von elektrischen Einrichtungen derart auszugestalten, dass der Sensorteil eine gedruckte Schaltung ist und dass der Impulsgenerator ein integrierter Schaltkreis mit einem Signaleingang und zwei Signalausgängen ist, wobei der eine Signalausgang mit dem einen der zwei Metallplättchen, der Signaleingang mit dem anderen der zwei Metallplättchen und der zweite Signalausgang, der ein vom Eingangssignal beeinflusstes Ausgangssignal abgibt, über eine Dioden- und Kondensatorschaltung gleichzeitig mit einem NPN- und einem PNP-Darlington-Transistor verbunden ist, derart, dass die beiden Transistoren das Ausgangssignal in je einen einzigen Impuls bestimmter Länge umformen, der ein Schaltelement ansteuert.

Anhand der beiliegenden Zeichnungen wird die Erfindung an zwei Ausführungsbeispielen erläutert. Es zeigen

Fig. 1 ein Blockschaltbild des Netzteilen der Schaltungsanordnung,

Fig. 2 ein Blockschaltbild der Schaltungsanordnung mit einer Darstellung des Sensorteils,

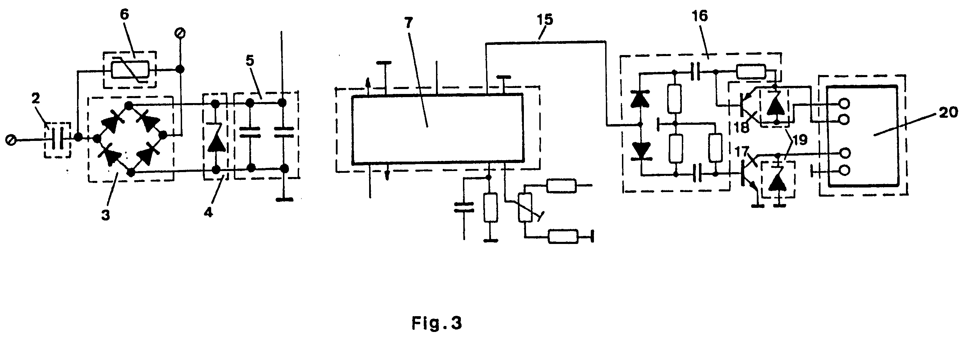

Fig. 3 ein Prinzipschaltbild eines Ausführungsbeispiels der Schaltungsanordnung,

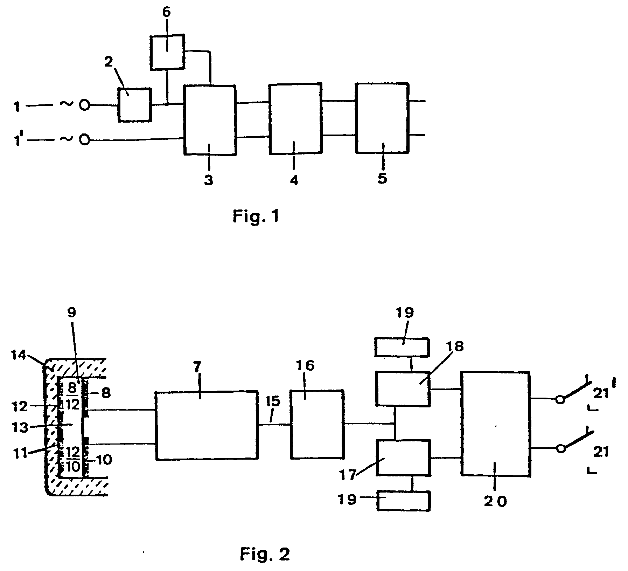

Um ein erwärmungsfreies Arbeiten der Schaltungsanordnung zu gewährleisten, wird der Netzteil gemäss Fig. 1 über einen Kondensator 2 bestimmter Grösse an das Netz 1 und 1' gekoppelt. In der Folge wird die Spannung in einer Gleichricherbrücke 3 gleichgerichtet, mittelst der Diode 4 begrenzt und vermittelst von Kondensatoren 5 geglättet. Zum Schutz gegen Netz-Transienten wie z.B. von Spannungsspitzen beim Abschalten grosser Lasten, Blitzeinschlägen usw. ist ein schneller, leistungsfähiger Zinkoxid-Varistor 6 eingebaut.

Der integrierte Schaltkreis 7 in Fig. 2 erzeugt ein rechteckiges Pulssignal, das kontinuierlich einem metallischen Plättchen 8 auf der Rückseite einer doppelseitig gedruckten Schaltung 9 zugeführt wird. Ein zweites metallisches Plättchen 10 ist auf derselben Seite der gedruckten Schaltung 9 und neben dem Plättchen 8 angebracht. Auf der dem Benützer zugekehrten Vorderseite 11 der gedruckten Schaltung 9 überdeckt ein drittes metallisches Plättchen 12 die Anordnung der beiden Plättchen 8 und 10. Ueber die so erhaltenen Seriekapazitäten 8/12 und 12/10 wird das kontinuierlich gepulste Signal wieder dem integrierten Schaltkreis 7 als Nutz-Eingangssignal zugeführt.

Um die Vorteile von Beleuchtung, zweidimensionaler Ausführung und totaler elektrischer Sicherheit nutzen zu können, wurde der Sensorteil 13 in einen durchsichtigen Kunststoffblock 14 eingepasst. Es besteht so keine Verletzungsmöglichkeit und es ergibt sich so eine grosse Reinigungsfreundlichkeit.

Das berührungslose Schalten ist dadurch charakterisiert, dass das metallische Plättchen 12 nicht berührt werden muss, sondern, dass der Schaltvorgang bereits bei der Annäherung eines Körpers eingeleitet wird. Die Empfindlichkeit kann stufenlos eingestellt werden, sodass der Schaltvorgang selbst dann ausgelöst werden kann, wenn der Kunststoffblock auch nicht berührt wird.

Beim Annähern eines Körpers an den mit dem metallischen Plättchen 12 versehenen Kunststoffblock 14 wird die Amplitude des Eingangssignals durch die Körperkapazität drastisch vermindert, was vom integrierten Schaltkreis 7 erkannt wird und ihn veranlasst, ein entsprechendes Ausgangssignal abzugeben.

Die Ansteuerung des Schaltelementes 20 erfolgt durch das Ausgangssignal 15 des integrierten Schaltkreises 7, indem dasselbe über Dioden und Kondensatoren 16 gleichzeitig einem NPN 17 und einem PNP 18 Darlington-Transistor zugeführt wird, die das Signal in je einen einzigen Impuls bestimmter Länge umformen. Die Transistoren 17 und 18 sind mittels Zenerdioden 19 gegen Spannungsspitzen geschützt. Bei Ausfall der Stromversorgung wird automatisch ein Aus-Befehl erteilt.

Als Schaltelement ist ein Starkstromrelais in Kleinstbauweise, in bistabiler Ausführung und mit zwei parallel geschalteten Wechselkontakten eingesetzt. Zur Erhöhung der Schalthäufigkeit, der Schaltleistung und der Schaltsicherheit sind beide Wechselkontakte 21, 21' parallel geschaltet. Bei Stromausfall wird gemäss Befehl der Ansteuerungseinheit automatisch aus-, bzw. umgeschaltet.

Um gemäss Vorschrift SEV die galvanische Netz-Trennung einhalten zu können und trotzdem die Vorteile eines Halbleiterschalters benützen zu können, wird bei Verwendung eines Halbleiterrelais dieses mittels einer Einschaltverzögerung erst dann eingeschaltet, nachdem das Relais selbst zur Gewährleistung der galvanischen Netz-Trennung eingeschaltet worden ist und beim Ausschaltvorgang wird zuerst das Halbleiterrelais ausgeschaltet und unmittelbar danach auch das herkömmliche Relais.

## Patentanspruch

Schaltungsanordnung zum berührungslosen Schalten von elektrischen Einrichtungen mit einem Impulsgenerator, der rechteckförmige Impulssignale kontinuierlich einem Signaleingang eines Sensorteils zuführt, in welchem zwei in Serie geschaltete Kondensatoren angeordnet sind, die aus zwei auf einer Seite des Sensorteiles angeordneten Metallplättchen und einem auf der anderen, dem Benutzer zugewandten Seite angeordneten dritten Metallplättchen, welches die beiden anderen Metallplättchen überdeckt, bestehen, und welcher einen Signalausgang aufweist, an dem von der Annäherung eines Körpers an das dritte Metallplättchen beeinflussbare Ausgangssignale abgegeben werden, welche entsprechend umgeformt ein Schaltelement steuern, dadurch gekennzeichnet, dass der Sensorteil eine gedruckte Schaltung (9) ist und dass der Impulsgenerator ein integrierter Schaltkreis (7) mit einem Signaleingang und zwei Signalausgängen ist, wobei der eine Signalausgang mit dem einen der zwei Metallplättchen (8), der Signaleingang mit dem anderen der zwei Metallplättchen (10) und der zweite Signalausgang (15), der ein vom Eingangssignal beeinflusstes Ausgangssignal abgibt, über eine Dioden- und Kondensatorschaltung (16) gleichzeitig mit einem NPN- (17) und einem PNP- (18) Darlington-Transistor verbunden ist, derart, dass die beiden Transistoren das Ausgangssignal in je einen einzigen Impuls bestimmter Länge umformen, der ein Schaltelement (20) ansteuert.

## Revendication

Circuit pour la commutation sans contact d'installation électrique, avec un générateur d'impulsions qui délivre continuellement des signaux rectangulaires pulsés à l'entrée d'un capteur dans lequel deux condensateurs couplés en série sont montés, et qui se compose de deux plaquettes métalliques disposées d'un côté du capteur, et d'une troisième plaquette métallique placée de l'autre côté, celui dirigé vers l'utilisateur, et qui recouvre les deux autres plaquettes métalliques, et qui présente une sortie de signal sur laquelle, à l'approche d'un corps près de la troisième plaquette métallique, seront donnés des signaux de sortie pouvant être influencés, et qui, convenablement convertis, commandent un élément de commutation, caractérisé par le fait que le capteur est un circuit imprimé (9) et que le générateur d'impulsions est un circuit intégré (7) qui a une entrée et deux sorties, où l'une des sorties est reliée à l'une des deux plaquettes métallique (8), l'entrée avec l'autre des deux plaquettes métalliques (10) et la deuxième sortie (15), qui fournit un signal influencé par le signal d'entrée, est reliée simultanément par un circuit de diodes et condensateurs (16) avec des transistors Darlington NPN (17) et PNP (18), de telle sorte que chacun des deux transistors convertisse le signal de sortie en une seule impulsion de longueur définie, qui commande un élément de commutation (20).

### Claim

Circuit arrangement for contactless switching of electrical equipments with a pulse generator which continuously feeds rectangular pulse signals to a signal input of a sensor unit, two capacitors connected in series being installed inside said sensor unit, said capacitors consisting of two metal plates arranged on one side the sensor unit and a third metal plate arranged on the side facing the user and covering the two other metal plates, and which has a signal output at which output signals which are influencable by a body approaching the third metal plate are issued, said signals being translated correspondingly in a switch element, wherein, the sensor unit is a printed circuit (9) and the pulse generator an integrated switching circuit (7) with a signal input and two signal outputs, whereas the one signal output is connected to one of the two metal plates (8), the signal input to the other of the two metal plates (10) and the second signal output (15), which issues an output signal influenced by the input signal, simultaneously to a NPN (17) and a PNP (18) Darlington transistor via a diode and capacitor connection (16) to the effect that each of the two transistors converts the output signal into a single pulse of a specific length, said output signal actuating a switching element (20).

Fig. 1

Fig. 2

Fig. 3